# EUROPÄISCHE PATENTSCHRIFT

(11) **EP 2 925 805 B1**
(45) Veröffentlichungstag und Bekanntmachung des Hinweises auf die Patenterteilung: **27.02.2019**
(21) Anmeldenummer: 13785850.2
(22) Anmeldetag: 31.10.2013
(51) Int. Cl.: C08G 77/60, C07F 7/08

(54) **VERFAHREN ZUM HERSTELLEN KOHLENSTOFFHALTIGER HYDRIDOSILANE**
METHOD FOR PRODUCING HYDRIDOSILANES CONTAINING CARBON
PROCÉDÉS DE PRÉPARATION D'HYDRIDOSILANES CONTENANT DU CARBONE

(30) Priorität: 27.11.2012 DE 102012221669
(43) Veröffentlichungstag der Anmeldung: 07.10.2015
(73) Patentinhaber: Evonik Degussa GmbH, 45128 Essen (DE)
(72) Erfinder: TRAUT, Stephan, 79541 Lörrach Brombach (DE); WIEBER, Stephan, 76137 Karlsruhe (DE); PATZ, Matthias, 46240 Bottrop (DE); CÖLLE, Michael, 90596 Schwanstetten (DE); STÜGER, Harald, A-8042 Graz (AT); WALKNER, Christoph, A-8010 Graz (AT)
(86) Internationale Anmeldenummer: PCT/EP2013/072755
(87) Internationale Veröffentlichungsnummer: WO 2014/082815

(56) Entgegenhaltungen:
- US-A- 5 596 117
- US-A1- 2009 156 775
- Anonymous: "RÖMPP - Aluminiumchlorid - Georg Thieme Verlag KG", , 1. November 2003 (2003-11-01), XP055098340, Gefunden im Internet: URL:https://roempp.thieme.de/roempp4.0/do/ data/RD-01-01796 [gefunden am 2014-01-24]
- Prof Burkhard Dr ET AL: "Reduction Reactions Reduction of Carboxylic Acid Derivatives and Related Functionality", , 27. März 2008 (2008-03-27), XP055098342, Gefunden im Internet: URL:http://www-oc.chemie.uni-regensburg.de /OCP/ch/chb/oc5/Reduction_Reactions-08.pdf [gefunden am 2014-01-24]
- SEMENOV V V ET AL: "GRAFT COPOLYMERS OF POLYPHENYLSILANE WITH METHYL METHACRYLATE", POLYMER SCIENCE, INTERPERIODICA, BIRMINGHAM, AL, US, Bd. 37, Nr. 12, 1. Dezember 1995 (1995-12-01), Seiten 1206-1211, XP000551971, ISSN: 0965-545X

## Beschreibung

Die vorliegende Erfindung betrifft ein Verfahren zum Herstellen kohlenstoffhaltiger Hydridosilane, die kohlenstoffhaltigen Hydridosilane selbst und ihre Verwendung.

Hydridosilane bzw. ihre Gemische sind in der Literatur als mögliche Edukte für die Erzeugung von Siliciumschichten beschrieben, die u.a. Anwendung in der Halbleiterindustrie finden. Dabei sind unter Hydridosilanen Verbindungen zu verstehen, die im Wesentlichen lediglich Silicium- und Wasserstoffatome enthalten. Hydridosilane können gasförmig, flüssig oder fest sein und sind - im Falle von Feststoffen - im Wesentlichen löslich in Lösemitteln wie Toluol oder Cyclohexan oder in flüssigen Silanen wie Cyclopentasilan. Als Beispiele seien Monosilan, Disilan, Trisilan, Cyclopentasilan und Neopentasilan genannt. Hydridosilane mit mindestens drei bzw. vier Siliciumatomen können eine lineare, verzweigte oder (ggf. bi-/poly-)cyclische Struktur mit Si-H-Bindungen aufweisen und lassen sich durch die jeweiligen generischen Formeln SiₙH₂ₙ₊₂ (linear bzw. verzweigt; mit n ≥ 2), SiₙH₂ₙ (cyclisch; mit n ≥ 3) oder SiₙH₂₍ₙ₋ᵢ₎ (bi- bzw. polycyclisch; n ≥ 4; i = {Zahl der Cyclen} - 1) beschreiben.

Dabei lassen sich Siliciumschichten prinzipiell über verschiedene Verfahren herstellen. Von diesen haben jedoch Sputtertechniken den Nachteil, dass sie im Hochvakuum durchgeführt werden müssen. Gasphasenabscheidungsprozesse wie z.B. CVD oder PVD haben weiterhin den Nachteil, dass sie i) im Falle einer thermischen Reaktionsführung den Einsatz sehr hoher Temperaturen oder ii) im Falle des Einbringens der erforderlichen Energie für die Zersetzung des Precursors in Form von elektromagnetischer Strahlung hohe Energiedichten erfordern. In beiden Fällen ist es nur mit höchstem apparativem Aufwand möglich, die zur Zersetzung des Precursors benötigte Energie gezielt und einheitlich einzubringen. Da auch die anderen Verfahren zur Herstellung von Siliciumschichten nachteilig sind, werden somit Siliciumschichten bevorzugt über Abscheidungen aus der flüssigen Phase gebildet.

Bei derartigen Flüssigphasen-Verfahren zur Herstellung von Siliciumschichten werden flüssige Edukte (ggf. fungierend als Lösemittel für weitere Additive und/oder Dotierstoffe) oder flüssige Lösungen enthaltend die (selbst flüssigen oder festen) Edukte (und ggf. weitere Additive und/oder Dotierstoffe) auf das zu beschichtende Substrat aufgebracht und nachfolgend thermisch und/oder mit elektromagnetischer Strahlung zu einer Siliciumschicht konvertiert. So offenbart z.B. US 2008/0022897 A1 Dotierstoffe aufweisende Hydridosilan-haltige Beschichtungszusammensetzungen zur Herstellung dünner Halbleiterfilme.

Auch, wenn prinzipiell viele Hydridosilane für die Siliciumschichtherstellung eingesetzt werden können, hat sich gezeigt, dass nur höhere Hydridosilane, d.h. Hydridosilane mit mindestens 10 Siliciumatomen, oder deren Lösungen bei Beschichtung üblicher Substrate deren Oberfläche gut bedecken und zu homogenen Schichten mit wenigen Defekten führen können. Aus diesem Grunde sind Verfahren zur Herstellung höherer Hydridosilane von Interesse. Viele höhere Hydridosilane lassen sich durch Oligomerisierung niederer Hydridosilane herstellen. Bei einer solchen Oligomerisierung niederer Hydridosilane wird formal betrachtet aus zwei oder mehr niederen Hydridosilanmolekülen nach Abstraktion von Wasserstoff und/oder kleineren Hydridosilylresten ein Hydridosilanmolekül höheren Molekulargewichts aufgebaut.

Aus reinen Hydridosilanen hergestellte Siliciumschichten weisen jedoch für Halbleiteranwendungen, insbesondere für optoelektronische Anwendungen, oft noch nicht zufriedenstellende Eigenschaften auf. So wäre es wünschenswert, siliciumbasierte Schichten mit größeren optischen Bandlücken (die prinzipiell dazu geeignet sind, in Solarzellen Strahlung über einen weiten Wellenlängebereich zu absorbieren, d.h. ein "wide bandgap"-Material darstellen) herstellen zu können. Auch wünschenswert wäre, siliciumbasierte Schichten mit einem besonders kleinen Brechungsindex herzustellen, die eine bessere optische Einkopplung der Strahlung ermöglichen. Weiterhin wäre es wünschenswert, siliciumbasierte Schichten mit einer besonders guten optischen Transmission herstellen zu können.

US 5,866,471 A offenbart Verfahren zur Erzeugung dünner Halbleiterschichten, bei denen neben Lösungen von Hydridosilanen auch Lösungen aufweisend alkylierte Hydridosilane eingesetzt werden. Generelle Verfahren zur Herstellung der alkylierten Hydridosilane werden nicht beschrieben. In den Beispielen wird ein Verfahren zur Herstellung alkylierter Hydridosilane ein Verfahren offenbart, bei dem metallisches Natrium eingesetzt wird. Dies hat jedoch den Nachteil, dass entstehende Salze aufwändig entfernt werden müssen und als Nebenprodukt nachteilige metallierte Silanverbindungen entstehen können.

US 6,020,447 A offenbart ein Verfahren zur Herstellung alkylierter Hydridosilane, bei dem ein Polysilanprecursor mit einem Reduktionsmittel, bevorzugt Natrium, Kalium, Lithium und ihren Legierungen, umgesetzt wird. Auch hierbei entstehen nachteilige ionische Nebenprodukte und das Reduktionsmittel muss aufwändig entfernt werden.

US 5,700,400 A offenbart im Rahmen eines Verfahrens zur Herstellung eines halbleitenden Materials ein Zwischenprodukt einer dehydrogenierenden Kondensation von ggf. alkyliertem Mono-, Di- oder Trisilan. Die Kondensation erfolgt jedoch unter Zugabe eines Katalysators ausgewählt aus einem Metall oder einer Metallverbindung bestimmter Gruppen des Periodensystems. Diese Katalysatoren haben jedoch Nachteile. Insbesondere ist nachteilig, dass ihre Entfernung aus dem Reaktionsgemisch sehr aufwändig ist, wenn besonders reine Siliciumschichten erzeugt werden sollen.

Gegenüber dem geschilderten Stand der Technik stellt sich somit die Aufgabe, ein Verfahren zum Herstellen kohlenstoffhaltiger Hydridosilane bereitzustellen, das die Nachteile des Standes der Technik vermeidet. Insbesondere ist es die Aufgabe der vorliegenden Erfindung, ein Verfahren zum Herstellen kohlenstoffhaltiger Hydridosilane bereitzustellen, bei dem keine Reduktionsmittel oder Katalysatoren aufwändig entfernt werden müssen und bei dem keine nachteiligen Nebenprodukte entstehen.

Die sich somit stellende Aufgabe wird erfindungsgemäß gelöst durch ein Verfahren zum Herstellen kohlenstoffhaltiger Hydridosilane, bei dem
- ein ggf. bor- oder phosphordotiertes Hydridosilan
- katalysator- und reduktionsmittelfrei
- mit mindestens einer Kohlenstoffquelle ausgewählt aus
   - linearen oder verzweigten Carbosilanen der generischen Formel Si_{b}H_{2b+2-y}R_{y} mit b ≥ 2, 1 ≤ y ≤ 2b+2 und R = -C₁-C₁₀-Alkyl, -C₆-C₁₀-Aryl, -C₇-C₁₄-Aralkyl,
   - cyclischen Carbosilanen der generischen Formel Si_{c}H_{2c-y}R_{y} mit c ≥ 3, 1 ≤ y ≤ 2c und R = -C₂-C₁₀-Alkyl, -C₆-C₁₀-Aryl, -C₇-C₁₄-Aralkyl,
   - halogenierten Kohlenwasserstoffen der generischen Formel CₙH_{2n+2-y}X_{y} mit 1 ≤ n ≤ 5, 1 ≤ y ≤ 12 und X = F, Cl, Br, I
   - Carbenen der generischen Formel CRR' mit R, R'
      = -H, -F, -Br, -I, -C₁-C₁₀-(cyclo)Alkyl, -C₂-C₁₀-(cyclo)Alkenyl, -C₆-C₁₀-Aryl, -C₁-C₁₀-(cyclo)Heteroalkyl, -C₂-C₁₀-Heteroalkenyl, -C₅-C₁₀-Heteroaryl, -C₇-C₁₄-Aralkyl,
      -OR" mit R" = -C₁-C₁₀-Alkyl, -C₂-C₁₀-(cyclo)Alkenyl, -C₆-C₁₀-Aryl,
      -NR'''₂ mit R''' = -C₁-C₁₀-Alkyl, -C₂-C₁₀-(cyclo)Alkenyl, -C₆-C₁₀-Aryl,
      -SiₙR^{IV}ₙ₊₁ mit R^{IV} = -H, -C₁-C₁₀-(cyclo)Alkyl, -C₂-C₁₀-(cyclo)Alkenyl, -C₆-C₁₀-Aryl, -(CO)-R^{v} mit R^{v} = -H, -C₁-C₁₀-(cyclo)Alkyl, -C₂-C₁₀-(cyclo)Alkenyl, -C₆-C₁₀-Aryl, -(CO)-OR^{vi} mit R^{vi} = -H, -C₁-C₁₀-(cyclo)Alkyl, -C₂-C₁₀-(cyclo)Alkenyl, -C₆-C₁₀-Aryl, -CN, -NC,
      -SR^{vii} mit R^{vii} = -H, -C₁-C₁₀-(cyclo)Alkyl, -C₂-C₁₀-(cyclo)Alkenyl, -C₆-C₁₀-Aryl,
      -S(O)₂R^{viii} mit R^{viii} = -H, -C₁-C₁₀-(cyclo)Alkyl, -C₂-C₁₀-(cyclo)Alkenyl, -C₆-C₁₀-Aryl,
      -P(R^{ix})₂ mit R^{ix} = -H, -C₁-C₁₀-(cyclo)Alkyl, -C₂-C₁₀-(cyclo)Alkenyl, -C₆-C₁₀-Aryl, oder
      wobei R und R' gemeinsam einen zweizähnigen verbrückenden Rest ausgewählt aus =C₃-C₂₀-(cyclo)Alkyl, =C₃-C₂₀-(cyclo)Alkenyl, =C₃-C₂₀-(cyclo)Heteroalkyl, =C₃-C₂₀-Heteroalkenyl und =C₆-C₁₄-(Hetero)Aralkyl darstellen,
- Carbenanalogen, insbesondere CO und CN⁻,
- Alkylaziden der generischen Formel N₃R^{x} mit R^{x} = -C₁-C₁₀-(cyclo)Alkyl, -C₂-C₁₀-(cyclo)Alkenyl, -C₆-C₁₀-Aryl, -C₁-C₁₀-(cyclo)Heteroalkyl, -C₂-C₁₀-Heteroalkenyl, -C₅-C₁₀-Heteroaryl, -C₇-C₁₄-Aralkyl,
- Diazomethan H₂CN₂
- Dimethylsulfat C₂H₆O₄S
- oder Alkoholen der generischen Formel HOR^{xi} mit R^{xi} = -C₁-C₁₀-(cyclo)Alkyl, -C₂-C₁₀-(cyclo)Alkenyl, -C₆-C₁₀-Aryl, -C₁-C₁₀-(cyclo)Heteroalkyl, -C₂-C₁₀-Heteroalkenyl, -C₅-C₁₀-Heteroaryl, -C₇-C₁₄-Aralkyl
umgesetzt wird.

Bei den als Edukt einzusetzenden Hydridosilanen handelt es sich um Verbindungen, die im Wesentlichen lediglich Silicium- und Wasserstoffatome enthalten. Sie können zu einem geringen Anteil Dotierstoffatome, insbesondere Bor oder Phosphor aufweisen. Bevorzugt einsetzbare Hydridosilane genügen der generischen Formel Siₙ{BH}ₓ{PH}_{y}H₂ₙ₊₂ mit n = 3 - 10, x = 0 oder 1 und y = 0 oder 1, mit der Maßgabe, dass mindestens einer der Parameter x oder y = 0 ist. Bei diesen Verbindungen handelt es sich um ggf. Bor- oder Phosphor-dotierte Hydridosilane, die linear oder verzweigt sein können. Besonders gut geeignet sind Hydridosilane der generischen Formel Siₙ{BH}ₓH₂ₙ₊₂ mit n = 3 - 10, x = 0 oder 1. Ganz besonders gut lässt sich das erfindungsgemäße Verfahren mit Hydridosilanen der generischen Formel SiₙH₂ₙ₊₂ mit n = 3 - 10 durchführen. Entsprechende Verbindungen sind lineare oder verzweigte Hydridosilane. Ganz besonders bevorzugt sind die Hydridosilane SiH(SiH₃)₃, Si(SiH₃)₄ und Si(SiH₃)₃(SiH₂siH₃).

Bei der Oligomerisierung der Hydridosilane in Gegenwart der Kohlenstoffquelle erfolgt ein Aufbau von im Vergleich zu den eingesetzten Hydridosilanen höhermolekularen, kohlenstoffhaltigen Hydridosilanoligomeren. Diese weisen aufgrund des erfolgenden Bindungsbruches und der anschließender Rekombination der eingesetzten Hydridosilane und ggf. auch der Kohlenstoffquellen bei der Synthese eine verzweigte Struktur auf.

Das erfindungsgemäße Verfahren hat weiterhin den Vorteil, dass Oligomere mit einer besonders homogenen Verteilung der Kohlenstoff- und Siliciumatome und infolgedessen auch mit diesen siliciumhaltige Schichten mit einer besonders homogenen Verteilung dieser Atome hergestellt werden können. Weiterhin hat das erfindungsgemäße Verfahren den Vorteil, dass auch geringe Kohlenstoffkonzentrationen im Oligomer gut eingestellt werden können.

Das erfindungsgemäße Verfahren wird katalysator- und reduktionsmittelfrei durchgeführt, d.h. es wird ohne die Anwesenheit von Reduktionsmitteln (insbesondere ohne die Anwesenheit von elementaren Alkali- oder Erdalkalimetallen) und ohne die Anwesenheit von Verbindungen, die die Oligomerisierung zum kohlenstoffhaltigen Hydridosilan katalysieren würden (insbesondere ohne die Anwesenheit von Übergangsmetallen, Lanthaniden, Übergangsmetallverbindungen oder Lanthanidverbindungen) durchgeführt.

Das erfindungsgemäße Verfahren wird mit mindestens einer Kohlenstoffquelle durchgeführt. Somit kann das ggf. bor- oder phosphordotierte Hydridosilan mit einer oder mehreren Kohlenstoffquellen umgesetzt werden. Bevorzugt, weil dies zu besonders guten kohlenstoffhaltigen Hydridosilanen führt, wird das erfindungsgemäße Verfahren so durchgeführt, dass das ggf. bor- oder phosphordotierte Hydridosilan mit einer Kohlenstoffquelle umgesetzt wird. Die Kohlenstoffquellen sind ausgewählt aus im folgenden näher erläuterten bestimmten linearen, verzweigten und cyclischen Carbosilanen, halogenierten Kohlenwasserstoffen, Carbenen, Alkylaziden, Alkoholen sowie den Verbindungen Diazomethan und Dimethylsulfat. Wie diese Verbindungen hergestellt werden können ist dem Fachmann dabei bekannt.

Als Kohlenstoffquellen können lineare oder verzweigte Carbosilane der generischen Formel Si_{b}H_{2b+2-y}R_{y} mit b ≥ 2, 1 ≤ y ≤ 2b+2 und R = C₁-C₁₀-Alkyl, C₆-C₁₀-Aryl, C₇-C₁₄-Aralkyl eingesetzt werden. Unter "C₁-C₁₀-Alkyl"-Resten sind dabei hier und im Folgenden Reste mit 1 bis 10 Kohlenstoffatomen zu verstehen. Entsprechend weisen "C₆-C₁₀-Aryl"-Reste 6 bis 10 Kohlenstoffatome und "C₇-C₁₄-Aralkyl"-Reste 7 bis 14 Kohlenstoffatome auf. Eine Präfix "Cₓ-C_{y}" bezeichnet somit immer hier und im Folgenden den Mindestwert x und den Maximalwert y der Kohlenstoffe für den im Folgenden genauer bezeichneten, bevorzugten Rest. Alle Alkylreste können linear oder auch verzweigt vorliegen. Weiterhin können alle Alkyl-, Aryl- und Aralkylreste Substituenten tragen. Insbesondere können alle Alkyl-, Aryl- und Aralkylreste halogeniert sein. Die als Kohlenstoffquelle einsetzbaren linearen oder verzweigten Carbosilane können ausschließlich Kohlenstoff-haltige Reste aufweisen (und somit "reine" Carbosilane sein) oder neben diesen auch noch direkt an Silicium gebundene Wasserstoffatome aufweisen (und somit Hydrido-Carbosilane sein). Bevorzugt sind lineare oder verzweigte Hydrido-Carbosilane der generischen Formel Si_{b}H_{2b+2-y}R_{y} mit b = 2 - 20, y = 1 bis 2b+1 und R = C₁-C₁₀-Alkyl, C₆-C₁₀-Aryl, C₇-C₁₄-Aralkyl, mit denen sich eine höhere Reaktivität im Vergleich zu "reinen" linearen oder verzweigten Carbosilanen ergibt und mit denen daneben auch eine homogenere Verteilung des Kohlenstoffs im Oligomer erzielt werden kann.

Als Kohlenstoffquellen eingesetzt werden können auch cyclische Carbosilane der generischen Formel Si_{c}H_{2c-y}R_{y} mit c ≥ 3, 1 ≤ y ≤ 2c und R = C₂-C₁₀-Alkyl, C₆-C₁₀-Aryl, C₇-C₁₄-Aralkyl. Alle Alkylreste können linear oder auch verzweigt vorliegen. Weiterhin können alle Alkyl-, Aryl- und Aralkylreste Substituenten tragen. Insbesondere können alle Alkyl-, Aryl- und Aralkylreste halogeniert sein. Die als Kohlenstoffquelle einsetzbaren cyclischen Carbosilane können ausschließlich Kohlenstoff-haltige Reste aufweisen (und somit "reine" Carbosilane sein) oder neben diesen auch noch direkt an Silicium gebundene Wasserstoffatome aufweisen (und somit Hydrido-Carbosilane sein). Bevorzugt sind cyclische wasserstoffhaltige Carbosilane der generischen Formel Si_{c}H_{2c-y}R_{y} mit c = 3 - 20, y = 1 - (2c-1) und R = C₂-C₁₀-Alkyl, C₆-C₁₀-Aryl, C₇-C₁₄-Aralkyl, mit denen sich eine höhere Reaktivität im Vergleich zu "reinen" cyclischen Carbosilanen ergibt und mit denen eine homogenere Verteilung des Kohlenstoffs im Oligomer erzielt werden kann.

Als Kohlenstoffquelle können auch halogenierte Kohlenwasserstoffe der generischen Formel CₙH_{2n+2-y}X_{y} mit 1 ≤ n ≤ 5, 1 ≤ y ≤ 12 und X = F, Cl, Br, I eingesetzt werden. Weiter bevorzugt werden halogenierte Verbindungen der generischen Formel CH_{4-y}X_{y} mit X = F, Cl, Br, I und y = 1 - 3 eingesetzt. Besonders bevorzugt werden Bromoform, Dibrommethan, Brommethan, Chloroform und Dichlormethan eingesetzt.

Als Kohlenstoffquellen eingesetzt werden können auch Carbene der generischen Formel CRR' mit R, R' = -H, -F, -Br, -I, -C₁-C₁₀-(cyclo)Alkyl, -C₂-C₁₀-(cyclo)Alkenyl, -C₆-C₁₀-Aryl, -C₁-C₁₀-(cyclo)Heteroalkyl, -C₂-C₁₀-(cyclo)Heteroalkenyl, -C₅-C₁₀-Heteroaryl, -C₇-C₁₄-Aralkyl, -OR" (mit R" = -C₁-C₁₀-(cyclo)Alkyl, -C₂-C₁₀-(cyclo)Alkenyl, -C₆-C₁₀-Aryl), -NR'''₂ (mit R''' = -C₁-C₁₀-(cyclo)Alkyl, -C₂-C₁₀-(cyclo)Alkenyl, -C₆-C₁₀-Aryl), -SiₙR^{IV}ₙ₊₁ (mit R^{IV} = -H, -C₁-C₁₀-(cyclo)Alkyl,-C₂-C₁₀-(cyclo)Alkenyl, -C₆-C₁₀-Aryl), -(CO)-R^{v} (mit R^{v} = -H, -C₁-C₁₀-(cyclo)Alkyl, -C₂-C₁₀-(cyclo)Alkenyl, -C₆-C₁₀-Aryl), -(CO)-OR^{vi} (mit R^{vi} = -H, -C₁-C₁₀-(cyclo)Alkyl, -C₂-C₁₀-(cyclo)Alkenyl, -C₆-C₁₀-Aryl), -CN, -NC, -SR^{vii} (mit R^{vii} = -H, -C₁-C₁₀-(cyclo)Alkyl, -C₂-C₁₀-(cyclo)Alkenyl, -C₆-C₁₀-Aryl), -S(O)₂R^{viii} (mit R^{viii} = -H, -C₁-C₁₀-(cyclo)Alkyl, -C₂-C₁₀-(cyclo)Alkenyl, -C₆-C₁₀-Aryl), -P(R^{ix})₂ (mit R^{ix} = -H, -C₁-C₁₀-(cyclo)Alkyl, -C₂-C₁₀-(cyclo)Alkenyl, -C₆-C₁₀-Aryl). Eingesetzt werden können auch Carbene der generischen Formel CRR', bei denen R und R' gemeinsam einen zweizähnigen verbrückenden Rest ausgewählt aus =C₃-C₂₀-(cyclo)Alkyl, =C₃-C₂₀-(cyclo)Alkenyl, =C₃-C₂₀-(cyclo)Heteroalkyl, =C₃-C₂₀-(cyclo)Heteroalkenyl oder =C₆-C₁₄-(Hetero)Aralkyl darstellen. Alle Alkyl-, Alkenyl, Heteroalkyl-, und Heteroalkenylreste können linear oder auch verzweigt vorliegen. Weiterhin können alle Alkyl-, Alkenyl-, Aryl-, Heteroalkyl-, Heteroalkenyl-, Heteroaryl- und Aralkylreste an einzelnen, mehreren oder allen Positionen (insbesondere: an Kohlenstoffatomen und Stickstoffatomen) Substituenten tragen. Insbesondere können einzelne, mehrere oder alle dieser Positionen halogeniert oder mit C₃-C₆-Alkylresten substituiert sein. Besonders gute Ergebnisse können erzielt werden mit Carbenen der generischen Formel CRR', bei denen R und R' = -C₄-C₁₀-(cyclo)Alkyl, -C₄-C₁₀-(cyclo)Alkenyl, -C₄-C₁₀-Aryl, -C₄-C₁₀-(cyclo)Heteroalkyl, -C₄-C₁₀-Heteroalkenyl, -C₅-C₁₀-Heteroaryl, -C₇-C₁₄-Aralkyl ist oder bei denen R und R' gemeinsam einen zweizähnigen verbrückenden Rest ausgewählt aus =C₄-C₁₀-(cyclo)Alkyl, =C₄-C₁₀-(cyclo)Alkenyl, =C₄-C₁₀-(cyclo)Heteroalkyl, =C₄-C₁₀-(cyclo)Heteroalkenyl oder =C₆-C₁₀-(Hetero)Aralkyl darstellen.

Als Kohlenstoffquellen eingesetzt werden können ebenfalls Alkylazide der generischen Formel N₃R^{x} mit R^{x} = -C₁-C₁₀-(cyclo)Alkyl, -C₂-C₁₀-(cyclo)Alkenyl, -C₆-C₁₀-Aryl, -C₁-C₁₀-(cyclo)Heteroalkyl, -C₂-C₁₀-(cyclo)Heteroalkenyl, -C₅-C₁₀-Heteroaryl, -C₇-C₁₄-Aralkyl, die Verbindungen Diazomethan H₂CN₂, Dimethylsulfat C₂H₆O₄S, sowie Alkohole der generischen Formel HOR^{xi} mit R^{xi} = -C₁-C₁₀-(cyclo)Alkyl, -C₂-C₁₀-(cyclo)Alkenyl, -C₆-C₁₀-Aryl, -C₁-C₁₀-(cyclo)Heteroalkyl,-C₂-C₁₀-(cyclo)Heteroalkenyl, -C₅-C₁₀-Heteroaryl, -C₇-C₁₄-Aralkyl.

Vorteile, die für genannte Kohlenstoffquellen gegenüber anderen genannten Kohlenstoffquellen resultieren können, sind, dass sie besonders gut (d.h. insbesondere besonders schnell, in besonders hoher Ausbeute, zu besonders homogenen Produkten) führen. Auch können einige Kohlenstoffquellen besonders gut im Vergleich zu anderen Kohlenstoffquellen derselben Verbindungsklasse für die zu katalysierende Reaktion geeignet sein.

Besonders gut lässt sich weiterhin das erfindungsgemäße Verfahren durchführen, wenn das Hydridosilan die generische Formel SiₙH₂ₙ₊₂ mit n = 3-10 aufweist. Weiter bevorzugt erfolgt die katalysator- und reduktionsmittelfreie Umsetzung mit der mindestens einen Kohlenstoffquelle in Gegenwart mindestens einer weiteren Hydridosilanverbindung mit einem gewichtsmittleren Molekulargewicht von mindestens 500 g/mol.

Besonders gute bor- oder phosphordotierte Hydridosilane lassen sich aus Hydridosilanen der generischen Formel SiₙH₂ₙ₊₂ mit n = 3 - 10, einer Kohlenstoffquelle und mindestens einem Dotierstoff ausgewählt aus AlMe₃, AlCl₃, BCl₃, BF₃, Diboran (B₂H₆), BH₃:THF, BEt₃, BMe₃, PH₃ und P₄ herstellen, Besonders bevorzugt einsetzbare Dotierstoffe sind B₂H₆, BH₃:THF und P₄, die zu einer besonders guten Dotierung führen und die weiterhin den Vorteil haben, die elektrische Dunkelleitfähigkeit zu erhöhen Diese Oligomere sind aufgrund ihrer Bildung aus drei Edukten besonders homogen in Bezug auf die Verteilung ihrer Silicium-, Kohlenstoff- und Dotierstoffatome und führen infolgedessen zu besonders homogenen Schichten mit besonders guten elektrischen Eigenschaften.

Die Kohlenstoffquelle weist bevorzugt ein gewichtsmittleres Molekulargewicht von 300 bis 4.000 g/mol (gemessen in Cyclooktan gegen Polybutadien), auf. Diese gewichtsmittleren Molekulargewichte der Kohlenstoffquelle vermeiden besonders gut einen einseitigen Silicium- oder Kohlenstoffverlust bei der Oligomerisierung und Konvertierung zu vermeiden.

Das erfindungsgemäße Verfahren kann ebenso unter Anwesenheit einer Lewis-Säure durchgeführt werden. Bevorzugt ist jedoch keine Lewis-Säure anwesend.

Bevorzugt wird die Umsetzung zum kohlenstoffhaltigen Hydridosilanoligomer thermisch und/oder mit elektromagnetischer Bestrahlung (insbesondere mit IR-, VIS- oder UV-Strahlung) durchgeführt. Im Falle einer thermischen Behandlung wird dabei das Reaktionsgemisch bevorzugt auf eine Temperatur von 30 bis 235 °C erhitzt. Diese Temperaturen können mit Mitteln, die dem Fachmann bekannt sind, eingestellt werden. Unter UV-Bestrahlung ist weiterhin das Bestrahlen mit elektromagnetischer Strahlung mit Wellenlängen von 120 bis 380 nm zu verstehen. Unter VIS-Strahlung ist das Bestrahlen mit elektromagnetischer Strahlung mit Wellenlängen von 380 bis 750 nm zu verstehen. Unter IR-Bestrahlung ist schließlich das Bestrahlen mit elektromagnetischer Strahlung mit Wellenlängen von 750 nm bis 1 mm zu verstehen. Entsprechende Strahlung kann mit Mitteln, die dem Fachmann bekannt sind erzeugt werden. Bevorzugt wird die Umsetzung zum Oligomer thermisch oder mit UV-Strahlung durchgeführt. Bevorzugte Reaktionszeiten betragen weiterhin zwischen 0,1 und 12 h.

Die Reaktion kann in An- oder Abwesenheit eines Lösemittels erfolgen. Bevorzugt wird das erfindungsgemäße Verfahren ohne Lösemittel durchgeführt. Wird es doch in Gegenwart eines Lösemittels durchgeführt, können als bevorzugte Lösemittel Lösemittel ausgewählt aus der Gruppe bestehend aus linearen, verzweigten oder cyclischen gesättigten, ungesättigten oder aromatischen Kohlenwasserstoffen mit einem bis 12 Kohlenstoffatomen (ggf. partiell oder vollständig halogeniert), Ethern, Ketonen und Estern eingesetzt werden. Besonders bevorzugt sind n-Pentan, n-Hexan, n-Heptan, n-Oktan, n-Dekan, Dodekan, Cyclohexan, Cyclooctan, Cyclodekan, Dicyclopentan, Benzol, Toluol, m-Xylol, p-Xylol, Mesitylen, Tetrahydronaphtalin, Decahydronaphtalin, Diethylether, Dipropylether, Ethylenglycoldimethylether, Ethylenglycoldiethylether, Ethylenglycolmethylethylether, Diethylenglycoldimethylether, Diethylenglycoldiethylether, Diethylenglycolmethylethylether, Tetrahydrofuran, Aceton, p-Dioxan, Acetonitril, Dimethylformamid, Dimethylsulfoxid, Dichlormethan und Chloroform. Besonders gut einsetzbare Lösemittel sind die Kohlenwasserstoffe n-Pentan, n-Hexan, n-Hexan, n-Oktan, n-Dekan, Dodekan, Cyclohexan, Cyclooctan, Cyclodekan, Benzol, Toluol, m-Xylol, p-Xylol, Mesitylen. Das Lösemittel kann 0,01 bis 99 Gew.% der Gesamtmasse ausmachen.

Gegenstand der vorliegenden Erfindung ist weiterhin das nach dem erfindungsgemäßen Verfahren herstellbare kohlenstoffhaltige Hydridosilanoligomer.

Weiterhin ist Gegenstand der Erfindung die Verwendung der nach dem erfindungsgemäßen Verfahren herstellbaren Hydridosilanoligomere zur Herstellung elektronischer oder optoelektronischer Bauteilschichten, insbesondere für photovoltaische Anwendungen oder in Transistoren.

Ebenso Gegenstand der Erfindung ist die Verwendung der nach dem erfindungsgemäßen Verfahren herstellbaren Hydridosilane zur Herstellung siliciumhaltiger Schichten, vorzugsweise elementarer Siliciumschichten.

Die folgenden Beispiele sollen den Gegenstand der Erfindung weiter ergänzend erläutern, ohne selbst beschränkend zu wirken.

### Beispiele:

Synthese der höheren kohlenstoffhaltigen Poly-H-Silane
a) Neopentasilan (1,32 g) wird mit Methylisotetrasilan (1,18 g) und Boran-THF-Komplex (1,9 g; 1 M) gemischt. Die Reaktionslösung wird für 4 h bei 50 °C gerührt. Eine GPC-Analyse zeigt ein gewichtsmittleres Molekulargewicht von 500 g/mol.
b) Neopentasilan (3 g) wird mit Bromoform (3,48 mL) und AlCl₃ (0,145 g) gemischt und langsam auf 100 °C erhitzt. Dabei kann eine plötzlich einsetzende Reaktion unter Gasentwicklung beobachtet werden. Nach Abklingen der Reaktion wird die Lösung für weitere 3 h bei 140 °C refluxiert.
c) Neopentasilan (1 g) wird mit 1,3-Diisopropyl-imidazolium-2-ylidene (0,059 g) und Boran-THF-Komplex (1,46 g; 1 M) bei Raumtemperatur gemischt. Dabei kann eine plötzlich einsetzende Reaktion unter Gasentwicklung beobachtet werden. Nach Abklingen der Reaktion wird die Lösung nach Beispiel 3 beschichtet
d) Neopentasilan (1 g) wird mit Butanol (0,051 g) und Boran-THF-Komplex (1,46 g; 1 M) gemischt. Die Reaktionsmischung wird langsam auf 140°C erhitzt und für 3h bei 140°C gerührt, wobei eine Trübung der Lösung beobachtet werden kann.
e) Vergleichssynthese) Neopentasilan (1 g) wird mit Boran-THF-Komplex (1,46 g; 1 M) gemischt und bei 30°C für 3h gerührt. Eine GPC Analyse zeigt ein gewichtsmittleres Molekulargewicht von 580 g/mol.

### Schichtherstellung

### Beispiel 1:

Ein Glassubstrat wird mit einer Formulierung, bestehend aus einem Oligomer der Synthese a (0,15 g), Cyclooktan (0,06 g) und Toluol (0,54 g), bei 6000 U/min beschichtet. Der Film wird bei 500 °C für 60 s ausgehärtet. Die Schichtdicke beträgt 35 nm. Die optische Bandlücke beträgt 1,72 eV und die Leitfähigkeit von 1,52x10⁻⁷ S/cm.

### Beispiel 2:

Ein Glassubstrat wird mit einer Formulierung, bestehend aus einem Oligomer der Synthese b (0,2 g), Cyclooktan (0,06 g) und Toluol (1,14 g) bei 3000 U/min beschichtet. Der Film wird bei 500 °C für 60 s ausgehärtet. Die Schichtdicke beträgt 205 nm. Die optische Bandlücke liegt bei 2,42 eV und die elektrische Leitfähigkeit bei 2,1x10⁻¹¹ S/cm.

### Beispiel 3:

Ein Glassubstrat wird mit einer Formulierung, bestehend aus einem Oligomer der Synthese c (0,156 g), Cyclooktan (0,016 g) und Toluol (0,188 g) bei 1000 U/min beschichtet. Der Film wird bei 500 °C für 60 s ausgehärtet. Die Schichtdicke beträgt 101 nm. Die optische Bandlücke liegt bei 1,74 eV und die elektrische Leitfähigkeit bei 2,1x10-8 S/cm.

### Beispiel 4:

Ein Glassubstrat wird mit einer Formulierung, bestehend aus einem Oligomer der Synthese d (0,2 g), Cyclooktan (0,039 g) und Toluol (0,364 g) bei 1000 U/min beschichtet. Der Film wird bei 500 °C für 60 s ausgehärtet. Die Schichtdicke beträgt 144 nm. Die optische Bandlücke liegt bei 1,64 eV und die elektrische Leitfähigkeit bei 3,2x10-5 S/cm.

Vergleichsbeispiel:
Ein Glassubstrat wird mit einer Formulierung, bestehend aus einem Oligomer der Vergleichssynthese (0,1 g), Cyclooktan (0,1 g) und Toluol (0,9 g) bei 6000 U/min beschichtet. Der Film wird bei 500 °C für 60 s ausgehärtet. Die Schichtdicke beträgt 98 nm. Die optische Bandlücke liegt bei 1,54 eV.

Die UV-VIS-NIR-Spektren wurden auf dem Gerät Varian Cary 5000 gemessen. Die kohlenstoffhaltigen Siliciumschichten auf Glas (Corning Eagle XG) wurden in Transmission zwischen 200 nm und 1000 nm Wellenlänge gemessen und als Tauc-Plot aufgetragen. Die Extrapolation des linearen Bereiches auf die X-Achse ergibt die optische Bandlücke Eg.

## Patentansprüche

1. Verfahren zum Herstellen kohlenstoffhaltiger Hydridosilane, bei dem
- ein ggf. bor- oder phosphordotiertes Hydridosilan
- katalysator- und reduktionsmittelfrei
- mit mindestens einer Kohlenstoffquelle ausgewählt aus
- linearen oder verzweigten Carbosilanen der generischen Formel Si_{b}H_{2b+2-y}R_{y} mit b ≥ 2, 1 ≤ y ≤ 2b+2 und R = C₁-C₁₀-Alkyl, C₆-C₁₀-Aryl, C₇-C₁₄-Aralkyl,
- cyclischen Carbosilanen der generischen Formel Si_{c}H_{2c-y}R_{y} mit c ≥ 3, 1 ≤ y ≤ 2c und R = C₂-C₁₀-Alkyl, C₆-C₁₀-Aryl, C₇-C₁₄-Aralkyl,
- halogenierten Kohlenwasserstoffen der generischen Formel CₙH_{2n+2-y}X_{y} mit 1 ≤ n ≤ 5, 1 ≤ y ≤ 12 und X = F, Cl, Br, I
- Carbenen der generischen Formel CRR' mit R, R' =
-H, -F, -Br, -I, -C₁-C₁₀-(cyclo)Alkyl, -C₂-C₁₀-(cyclo)Alkenyl, -C₆-C₁₀-Aryl,
-C₁-C₁₀-(cyclo)Heteroalkyl, -C₂-C₁₀-(cyclo)Heteroalkenyl, -C₅-C₁₀-Heteroaryl, -C₇-C₁₄-Aralkyl,
-OR" mit R" = -C₁-C₁₀-(cyclo)Alkyl, -C₂-C₁₀-(cyclo)Alkenyl, -C₆-C₁₀-Aryl,
-NR'''₂ mit R''' = -C₁-C₁₀-(cyclo)Alkyl, -C₂-C₁₀-(cyclo)Alkenyl, -C₆-C₁₀-Aryl,
-SiₙR^{IV}ₙ₊₁ mit R^{IV} = -H, -C₁-C₁₀-(cyclo)Alkyl, -C₂-C₁₀-(cyclo)Alkenyl, -C₆-C₁₀-Aryl,
-(CO)-R^{v} mit R^{v} = -H, -C₁-C₁₀-(cyclo)Alkyl, -C₂-C₁₀-(cyclo)Alkenyl, -C₆-C₁₀-Aryl,
-(CO)-OR^{vi} mit R^{vi} = -H, -C₁-C₁₀-(cyclo)Alkyl, -C₂-C₁₀-(cyclo)Alkenyl, -C₆-C₁₀-Aryl, -CN, -NC,
-SR^{vii} mit R^{vii} = -H, -C₁-C₁₀-(cyclo)Alkyl, -C₂-C₁₀-(cyclo)Alkenyl, -C₆-C₁₀-Aryl,
-S(O)₂R^{viii} mit R^{viii} = -H, -C₁-C₁₀-(cyclo)Alkyl, -C₂-C₁₀-(cyclo)Alkenyl, -C₆-C₁₀-Aryl,
-P(R^{ix})₂ mit R^{ix} = -H, -C₁-C₁₀-(cyclo)Alkyl, -C₂-C₁₀-(cyclo)Alkenyl, -C₆-C₁₀-Aryl,
oder wobei R und R' gemeinsam einen zweizähnigen verbrückenden Rest ausgewählt aus =C₃-C₂₀-(cyclo)Alkyl, =C₃-C₂₀-(cyclo)Alkenyl, =C₃-C₂₀-(cyclo)Heteroalkyl, =C₃-C₂₀-(cyclo)Heteroalkenyl oder =C₆-C₁₄-(Hetero)Aralkyl darstellen,
- Carbenanalogen, insbesondere CO und CN⁻,
- Alkylaziden der generischen Formel N₃R^{x} mit R^{x} = -C₁-C₁₀-(cyclo)Alkyl, -C₂-C₁₀-(cyclo)Alkenyl, -C₆-C₁₀-Aryl, -C₁-C₁₀-(cyclo)Heteroalkyl, -C₂-C₁₀-(cyclo)Heteroalkenyl, C₅-C₁₀-Heteroaryl, -C₇-C₁₄-Aralkyl,
- Diazomethan H₂CN₂
- Dimethylsulfat C₂H₆O₄S
- oder Alkoholen der generischen Formel HOR^{xi} mit R^{xi} = -C₁-C₁₀-(cyclo)Alkyl, -C₂-C₁₀-(cyclo)Alkenyl, -C₆-C₁₀-Aryl, -C₁-C₁₀-(cyclo)Heteroalkyl, -C₂-C₁₀-(cyclo)Heteroalkenyl, -C₅-C₁₀-Heteroaryl, -C₇-C₁₄-Aralkyl
umgesetzt wird.

2. Verfahren nach Anspruch 1, **dadurch gekennzeichnet, dass** das als Edukt eingesetzte Hydridosilan die generische Formel Siₙ{BH}ₓ{PH}_{y}H₂ₙ₊₂ hat, wobei n = 3 - 10, x = 0 oder 1 und y = 0 oder 1, mit der Maßgabe, dass mindestens einer der Parameter x oder y = 0 ist.

3. Verfahren nach Anspruch 2, **dadurch gekennzeichnet, dass** das als Edukt eingesetzte Hydridosilan die generische Formel SiₙH₂ₙ₊₂ mit n = 3 - 10 hat.

4. Verfahren nach Anspruch 3, **dadurch gekennzeichnet, dass** die Umsetzung mit der mindestens einen Kohlenstoffquelle in Gegenwart mindestens einer weiteren Hydridosilanverbindung mit einem gewichtsmittleren Molekulargewicht von mindestens 500 g/mol erfolgt.

5. Verfahren nach einem der Ansprüche 3 oder 4, **dadurch gekennzeichnet, dass** die Umsetzung des Hydridosilans mit der Kohlenstoffquelle in Gegenwart mindestens eines Dotierstoffs ausgewählt aus AlMe₃, AlCl₃, BCl₃, BF₃, B₂H₆, BH₃:THF, BEt₃, BMe₃, PH₃ und P₄ erfolgt.

6. Verfahren nach einem der vorhergehenden Ansprüche, **dadurch gekennzeichnet, dass** die Kohlenstoffquelle ein gewichtsmittleres Molekulargewicht von 300 bis 4.000 g/mol aufweist.

7. Verfahren nach einem der vorhergehenden Ansprüche, wobei die Umsetzung thermisch und/oder mit elektromagnetischer Bestrahlung erfolgt.

8. Kohlenstoffhaltiges Hydridosilanoligomer, herstellbar nach einem Verfahren gemäß einem der vorhergehenden Ansprüche 1 bis 7.

9. Verwendung eines nach einem der Ansprüche 1 bis 7 herstellbaren kohlenstoffhaltigen Hydridosilanoligomers zur Herstellung elektronischer oder optoelektronischer Bauteilschichten, insbesondere für photovoltaische Anwendungen oder in Transistoren.

10. Verwendung eines nach einem der Ansprüche 1 bis 7 herstellbaren kohlenstoffhaltigen Hydridosilanoligomers zur Herstellung siliciumhaltiger Schichten, vorzugsweise elementarer Siliciumschichten.

## Claims

1. Process for preparing carbon-containing hydridosilanes, in which
- an optionally boron- or phosphorus-doped hydridosilane is reacted
- without catalyst and reducing agent
- with at least one carbon source selected from
- linear or branched carbosilanes of the generic formula Si_{b}H_{2b+2-y}R_{y} where b ≥ 2, 1 ≤ y ≤ 2b+2 and R = C₁-C₁₀-alkyl, C₆-C₁₀-aryl, C₇-C₁₄-aralkyl,
- cyclic carbosilanes of the generic formula Si_{c}H_{2c-y}R_{y} where c ≥ 3, 1 ≤ y ≤ 2c and R = C₂-C₁₀-alkyl, C₆-C₁₀-aryl, C₇-C₁₄-aralkyl,
- halogenated hydrocarbons of the generic formula CₙH_{2n+2-y}X_{y} where 1 ≤ n ≤ 5, 1 ≤ y ≤ 12 and X = F, Cl, Br, I,
- carbenes of the generic formula CRR' with R,
R' = -H, -F, -Br, -I, -C₁-C₁₀-(cyclo)alkyl, -C₂-C₁₀-(cyclo) alkenyl, -C₆-C₁₀-aryl,
-C₁-C₁₀- (cyclo) heteroalkyl, -C₂-C₁₀-(cyclo)heteroalkenyl, -C₅-C₁₀-heteroaryl, -C₇-C₁₄-aralkyl,
-OR" where R" = -C₁-C₁₀-(cyclo)alkyl, -C₂-C₁₀-(cyclo) alkenyl, -C₆-C₁₀-aryl,
-NR'''₂ where R''' = -C₁-C₁₀-(cyclo)alkyl, -C₂-C₁₀-(cyclo) alkenyl, -C₆-C₁₀-aryl,
-SiₙR^{IV}ₙ₊₁ where R^{IV} = -H, -C₁-C₁₀-(cyclo)alkyl,-C₂-C₁₀-(cyclo) alkenyl, -C₆-C₁₀-aryl,
-(CO)-R^{v} where R^{v} = -H, -C₁-C₁₀-(cyclo)alkyl,-C₂-C₁₀-(cyclo) alkenyl, -C₆-C₁₀-aryl,
-(CO)-OR^{vi} where R^{vi} = -H, -C₁-C₁₀-(cyclo) alkyl, -C₂-C₁₀-(cyclo)alkenyl, -C₆-C₁₀-aryl, -CN, -NC,
-SR^{vii} where R^{vii} = -H, -C₁-C₁₀-(cyclo)alkyl, -C₂-C₁₀-(cyclo) alkenyl, -C₆-C₁₀-aryl,
-S(O)₂R^{viii} where R^{viii} = -H, -C₁-C₁₀-(cyclo) alkyl, -C₂-C₁₀-(cyclo) alkenyl, -C₆-C₁₀-aryl,
-P(R^{ix})₂ where R^{ix} = -H, -C₁-C₁₀-(cyclo)alkyl,-C₂-C₁₀-(cyclo) alkenyl, -C₆-C₁₀-aryl,
or where R and R' together represent a bidentate bridging radical selected from =C₃-C₂₀-(cyclo) alkyl, =C₃-C₂₀-(cyclo)alkenyl, =C₃-C₂₀-(cyclo)heteroalkyl, =C₃-C₂₀-(cyclo) heteroalkenyl or =C₆-C₁₄-(hetero)aralkyl,
- carbene analogues, especially CO and CN⁻,
- alkyl azides of the generic formula N₃R^{x} where R^{x} = -C₁-C₁₀-(cyclo) alkyl, -C₂-C₁₀-(cyclo) alkenyl, -C₆-C₁₀-aryl, -C₁-C₁₀-(cyclo) heteroalkyl, -C₂-C₁₀-(cyclo)heteroalkenyl, C₅-C₁₀-heteroaryl, -C₇-C₁₄ -aralkyl,
- diazomethane H₂CN₂,
- dimethyl sulphate C₂H₆O₄S,
- or alcohols of the generic formula HOR^{xi} where R^{xi} = -C₁-C₁₀-(cyclo) alkyl, -C₂-C₁₀-(cyclo) alkenyl, -C₆-C₁₀-aryl, -C₁-C₁₀-(cyclo) heteroalkyl, -C₂-C₁₀-(cyclo)heteroalkenyl, -C₅-C₁₀-heteroaryl, -C₇-C₁₄-aralkyl.

2. Process according to Claim 1, **characterized in that** the hydridosilane used as the reactant has the generic formula Siₙ{BH}ₓ{PH}_{y}H₂ₙ₊₂ where n = 3 - 10, x = 0 or 1 and y = 0 or 1, with the proviso that at least one of the parameters x and y = 0.

3. Process according to Claim 2, **characterized in that** the hydridosilane used as the reactant has the generic formula SiₙH₂ₙ₊₂ where n = 3 - 10.

4. Process according to Claim 3, **characterized in that** the reaction with the at least one carbon source is effected in the presence of at least one further hydridosilane compound having a weight-average molecular weight of at least 500 g/mol.

5. Process according to either of Claims 3 and 4, **characterized in that** the reaction of the hydridosilane with the carbon source is effected in the presence of at least one dopant selected from AlMe₃, AlCl₃, BCl₃, BF₃, B₂H₆, BH₃:THF, BEt₃, BMe₃, PH₃ and P₄.

6. Process according to any of the preceding claims, **characterized in that** the carbon source has a weight-average molecular weight of 300 to 4000 g/mol.

7. Process according to any of the preceding claims, wherein the reaction is effected thermally and/or with electromagnetic irradiation.

8. Carbon-containing hydridosilane oligomer preparable by a process according to any of the preceding Claims 1 to 7.

9. Use of a carbon-containing hydridosilane oligomer preparable according to any of Claims 1 to 7 for production of electronic or optoelectronic component layers, especially for photovoltaic applications or in transistors.

10. Use of a carbon-containing hydridosilane oligomer preparable according to any of Claims 1 to 7 for production of silicon-containing layers, preferably of elemental silicon layers.

## Revendications

1. Procédé de fabrication d'hydridosilanes contenant du carbone, selon lequel
- un hydridosilane éventuellement dopé avec du bore ou du phosphore,
- est mis en réaction sans catalyseur et sans réducteur
- avec au moins une source de carbone choisie parmi :
- les carbosilanes linéaires ou ramifiés de formule générique Si_{b}H_{2b+2-y}R_{y} avec b ≥ 2, 1 ≤ y ≤ 2b+2 et R = alkyle en C₁-C₁₀, aryle en C₆-C₁₀, aralkyle en C₇-C₁₄,
- les carbosilanes cycliques de formule générique Si_{c}H_{2c-y}R_{y} avec c ≥ 3, 1 ≤ y ≤ 2c et R = alkyle en C₂-C₁₀, aryle en C₆-C₁₀, aralkyle en C₇-C₁₄,
- les hydrocarbures halogénés de formule générique CₙH_{2n+2-y}X_{y} avec 1 ≤ n ≤ 5, 1 ≤ y ≤ 12 et X = F, Cl, Br, I,
- les carbènes de formule générique CRR' avec R, R' =
H, F, Br, I, (cyclo) alkyle en C₁-C₁₀, (cyclo) alcényle en C₂-C₁₀, aryle en C₆-C₁₀, (cyclo)hétéroalkyle en C₁-C₁₀, (cyclo) hétéroalcényle en C₂-C₁₀, hétéroaryle en C₅-C₁₀, aralkyle en C₇-C₁₄,
-OR" avec R" = (cyclo) alkyle en C₁-C₁₀, (cyclo) alcényle en C₂-C₁₀, aryle en C₆-C₁₀,
-NR'''₂ avec R''' = (cyclo) alkyle en C₁-C₁₀, (cyclo) alcényle en C₂-C₁₀, aryle en C₆-C₁₀,
-SiₙR^{IV}ₙ₊₁ avec R^{IV} = H, (cyclo) alkyle en C₁-C₁₀, (cyclo) alcényle en C₂-C₁₀, aryle en C₆-C₁₀,
-(CO)-R^{v} avec R^{v} = H, (cyclo) alkyle en C₁-C₁₀, (cyclo) alcényle en C₂-C₁₀, aryle en C₆-C₁₀,
-(CO)-OR^{vi} avec R^{iv} = H, (cyclo) alkyle en C₁-C₁₀, (cyclo) alcényle en C₂-C₁₀, aryle en C₆-C₁₀,
-CN, -NC,
-SR^{vii} avec R^{vii} = H, (cyclo) alkyle en C₁-C₁₀, (cyclo) alcényle en C₂-C₁₀, aryle en C₆-C₁₀,
-S(O)₂R^{viii} avec R^{viii} = H, (cyclo) alkyle en C₁-C₁₀, (cyclo) alcényle en C₂-C₁₀, aryle en C₆-C₁₀,
-P(R^{ix})₂ avec R^{ix} = H, (cyclo) alkyle en C₁-C₁₀, (cyclo) alcényle en C₂-C₁₀, aryle en C₆-C₁₀,
ou dans lesquels R et R' représentent ensemble un radical bidentate pontant choisi parmi =(cyclo)alkyle en C₃-C₂₀, = (cyclo) alcényle en C₃-C₂₀, = (cyclo) hétéroalkyle en C₃-C₂₀, = (cyclo) hétéroalcényle en C₃-C₂₀ ou = (hétéro)aralkyle en C₆-C₁₄,
- les analogues de carbènes, notamment CO et CN⁻,
- les azides d'alkyle de formule générique N₃R^{x} avec R^{x} = (cyclo) alkyle en C₁-C₁₀, (cyclo) alcényle en C₂-C₁₀, aryle en C₆-C₁₀, (cyclo) hétéroalkyle en C₁-C₁₀, (cyclo) hétéroalcényle en C₂-C₁₀, hétéroaryle en C₅-C₁₀, aralkyle en C₇-C₁₄,
- le diazométhane H₂CN₂,
- le sulfate de diméthyle C₂H₆O₄S,
- ou les alcools de formule générique HOR^{xi} avec R^{xi} = (cyclo) alkyle en C₁-C₁₀, (cyclo) alcényle en C₂-C₁₀, aryle en C₆-C₁₀, (cyclo) hétéroalkyle en C₁-C₁₀, (cyclo) hétéroalcényle en C₂-C₁₀, hétéroaryle en C₅-C₁₀, aralkyle en C₇-C₁₄.

2. Procédé selon la revendication 1, **caractérisé en ce que** l'hydridosilane utilisé en tant que réactif a la formule générique Siₙ{BH}ₓ{PH}_{y}H₂ₙ₊₂, avec n = 3 à 10, x = 0 ou 1 et y = 0 ou 1, à condition qu'au moins un des paramètres x ou y = 0.

3. Procédé selon la revendication 2, **caractérisé en ce que** l'hydridosilane utilisé en tant que réactif a la formule générique SiₙH₂ₙ₊₂ avec n = 3 à 10.

4. Procédé selon la revendication 3, **caractérisé en ce que** la réaction avec ladite au moins une source de carbone a lieu en présence d'au moins un autre composé d'hydridosilane ayant un poids moléculaire moyen en poids d'au moins 500 g/mol.

5. Procédé selon l'une quelconque des revendications 3 ou 4, **caractérisé en ce que** la réaction de l'hydridosilane avec la source de carbone a lieu en présence d'au moins un agent dopant choisi parmi AlMe₃, AlCl₃, BCl₃, BF₃, B₂H₆, BH₃ : THF, BEt₃, BMe₃, PH₃ et P₄.

6. Procédé selon l'une quelconque des revendications précédentes, **caractérisé en ce que** la source de carbone présente un poids moléculaire moyen en poids de 300 à 4 000 g/mol.

7. Procédé selon l'une quelconque des revendications précédentes, dans lequel la réaction a lieu thermiquement et/ou avec un rayonnement électromagnétique.

8. Oligomère d'hydridosilane contenant du carbone, pouvant être fabriqué par un procédé selon l'une quelconque des revendications 1 à 7 précédentes.

9. Utilisation d'un oligomère d'hydridosilane contenant du carbone pouvant être fabriqué selon l'une quelconque des revendications 1 à 7 pour la fabrication de couches de composants électroniques ou optoélectroniques, notamment pour des applications photovoltaïques ou dans des transistors.

10. Utilisation d'un oligomère d'hydridosilane contenant du carbone pouvant être fabriqué selon l'une quelconque des revendications 1 à 7 pour la fabrication de couches contenant du silicium, de préférence de couches de silicium élémentaire.
